# EUROPÄISCHE PATENTSCHRIFT

(11) **EP 1 903 681 B1**
(45) Veröffentlichungstag und Bekanntmachung des Hinweises auf die Patenterteilung: **22.07.2009**
(21) Anmeldenummer: 06019806.6
(22) Anmeldetag: 21.09.2006
(51) Int. Cl.: H03L 7/091, H03L 7/07

(54) **Verfahren zur Taktsynchronisation eines elektrischen Geräts auf einen Referenztakt und elektrisches Gerät**
Method for synchronising the clock of an electrical apparatus with a reference clock and electrical apparatus
Procédé pour synchronisation de l'horloge d'un appareil électrique ave une horloge de référence et appareil électrique

(43) Veröffentlichungstag der Anmeldung: 26.03.2008
(73) Patentinhaber: SIEMENS AKTIENGESELLSCHAFT, 80333 München (DE)
(72) Erfinder: Pohle, Michael, 09125 Chemnitz (DE); Röhle, Holger, 09235 Burkhardtsdorf (DE)

(56) Entgegenhaltungen:
- EP-A- 1 557 951
- WO-A-20/04034631
- DE-C1- 10 022 486
- US-A- 6 052 034
- US-A- 6 166 606
- US-A1- 2003 197 537

## Beschreibung

Die Erfindung betrifft ein Verfahren zum Betrieb eines elektrischen Gerätes, insbesondere eines Automatisierungsgerätes, bei dem eine Korrektur einer Taktfrequenz erfolgt. Sie betrifft weiter ein elektrisches Gerät, insbesondere ein Automatisierungsgerät, mit Mitteln zur Durchführung des Verfahrens.

In Automatisierungssystemen ist häufig eine synchrone Bearbeitung bestimmter Steuerungsprogramme oder -routinen erforderlich, wobei die zu deren Ausführung vorgesehenen Automatisierungsgeräte kommunikativ verbunden sind und dazu häufig Hard- oder Softwareelemente zur Erzeugung und/oder Verarbeitung von Taktsignalen umfassen. Solche Taktsignale werden beispielsweise mittels Oszillatoren erzeugt, wobei eine Regelmäßigkeit der Taktsignale dabei von einer Qualität der verwendeten Bauteile sowie von anderen Faktoren, zu welchen auch Alterungsprozesse der Komponenten oder Umweltfaktoren, z.B. Temperatur oder Feuchtigkeit, zählen, beeinflusst wird. Sehr regelmäßige Taktsignale basieren auf Atom-Schwingungen, was bei Atomuhren eine hohe Präzision gewährleistet.

Zum Ausgleich von Laufzeitunterschieden zwischen einer Mehrzahl von Taktsignalen, beispielsweise aufgrund von Drift, erfolgt eine Synchronisation zumindest eines Taktsignals mit einem Referenztaktsignal, welches von einem, ein sehr regelmäßiges Taktsignal erzeugenden Taktfrequenzgeber, wie z.B. einer Atomuhr, erzeugt wird. Dabei erfolgt die Synchronisation der Taktfrequenzen umso genauer, je kürzer ein zur Synchronisation herangezogenes Zeitintervall ist, also je häufiger synchronisiert wird. Dabei muss jedoch ein Kompromiss zwischen der Häufigkeit der Synchronisation und der damit einhergehenden Belastung des Automatisierungssystems durch zusätzlich erforderliche Kommunikation geschlossen werden, weshalb die Zeitintervalle nicht beliebig klein gewählt werden können um die Isochronität der Taktsignale sicherzustellen. Nach einer Synchronisation lässt sich ein Auseinanderlaufen von Taktfrequenz und Referenztaktfrequenz bis zu einer erneuten Synchronisation nicht vermeiden, so dass es insoweit zu Ungenauigkeiten beim Betrieb des Automatisierungssystems kommen kann.

Aus der DE 100 22 486 C1 ist ein digitaler Phasenregelkreis bekannt, bei dem eine Differenz eines von einem Ausgabetakt eines Oszillators abgeleiteten, abhängigen Takts und eines Referenztakts bestimmt und in einen digitalen Stellwert ungesetzt wird, welcher dem Oszillator zur Einstellung dessen Ausgabetakts zugeführt wird.

Eine Aufgabe der Erfindung besteht darin, ein Verfahren anzugeben, bei dem die oben genannten Nachteile vermieden oder zumindest hinsichtlich ihrer Auswirkungen reduziert werden.

Diese Aufgabe wird gelöst durch ein Verfahren zum Betrieb eines elektrischen Gerätes, insbesondere eines Automatisierungsgerätes, bei welchem eine Korrektur einer ersten Taktfrequenz anhand einer zweiten Taktfrequenz sowie einer Referenztaktfrequenz erfolgt. Dabei wird zu mindestens einem vorgegebenen oder vorgebbaren ersten Zeitpunkt eine Taktdifferenz zwischen der zweiten Taktfrequenz und der Referenztaktfrequenz bestimmt. Aus dieser Taktdifferenz wird ein Korrekturwert abgeleitet, mit dem die erste Taktfrequenz beaufschlagt wird. Es erfolgt also quasi eine Synchronisation der ersten Taktfrequenz mit der Referenztaktfrequenz auf Basis der Differenz zwischen Referenztaktfrequenz und zweiter Taktfrequenz.

Weiterhin wird diese Aufgabe gelöst durch ein Computerprogramm mit Programmcodeanweisungen zur Implementierung des Verfahrens, wenn das Computerprogramm auf einem Computer ausgeführt wird, sowie durch ein Computerprogrammprodukt, insbesondere Speichermedium, mit dem durch einen Computer ausführbaren Computerprogramm.

Zudem wird diese Aufgabe durch ein elektrisches Gerät, insbesondere Automatisierungsgerät, mit Mitteln zur Durchführung des Verfahrens, insbesondere einer Verarbeitungseinheit und einem der Verarbeitungseinheit zugeordneten Speicher, gelöst.

In dem Speicher ist dabei das durch die Verarbeitungseinheit ausführbare Computerprogram gespeichert.

Durch dieses Verfahren wird eine regelmäßige und mit der Referenztaktfrequenz im Wesentlichen synchrone erste Taktfrequenz bei einer geringeren Häufigkeit der Synchronisation erzeugt, mittels welcher beispielsweise eine Drift kompensiert wird. Aus dieser geringeren Häufigkeit ergibt sich eine Minimierung der zusätzlichen, zur Synchronisation erforderlichen Kommunikation in dem Automatisierungssystem. Wenn die Synchronisierung permanent und automatisch stattfindet, ergibt sich eine automatische Kalibrierung ohne dass ein Anstoß von außen, z.B. eine Aktivität des Anwenders, erforderlich wäre, was zu einer Erhöhung eines Bedienkomforts des Automatisierungssystems führt.

Zweckmäßige Weiterbildungen des Verfahrens zum Betrieb eines elektrischen Gerätes sind Gegenstand der auf Anspruch 1 rückbezogeenn Unteransprüche. In Unteransprüchen verwendete Rückbeziehungen weisen auf die weitere Ausbildung des Gegenstandes des Hauptanspruches durch die Merkmale des jeweiligen Unteranspruches hin.

Bevorzugt ist vorgesehen, dass zu dem oder jedem vorgegebenen oder vorgebbaren ersten Zeitpunkt eine Synchronisation der zweiten Taktfrequenz mit der Referenztaktfrequenz erfolgt. Dabei wird im Zusammenhang mit der Synchronisation der zweiten Taktfrequenz mit der Referenztaktfrequenz die Taktdifferenz zwischen der zweiten Taktfrequenz und der Referenztaktfrequenz bestimmt. Herbei meint "im Zusammenhang" vor oder während, jedoch vor Abschluss der Synchronisation.

Eine geringfügige Ungleichheit von Taktfrequenzen und damit eine Differenz, z.B. zwischen der zweiten Taktfrequenz und der Referenztaktfrequenz, ergibt sich beispielsweise durch fertigungsbedingte Toleranzen von zur Taktfrequenzerzeugung vorgesehenen Bauelementen, durch Alterungs- oder Verschlei-ßerscheinungen des Taktfrequenzgebers oder durch eine beispielsweise temperaturbedingte Drift der ersten und zweiten Taktfrequenz. Eine solche Differenz kann beispielsweise als eine Differenz der zweiten Taktfrequenz und der Referenztaktfrequenz zu einem beliebigen Zeitpunkt, also eine relative Differenz, oder als eine Gesamtheit für einen Zeitraum nach der Synchronisation ermittelter Differenzen, also eine absolute Differenz, angegeben werden. Eine Synchronisation der zweiten Taktfrequenz mit der Referenztaktfrequenz setzt die absolute Differenz der Taktfrequenzen zurück, erleichtert somit die Ermittlung des Korrekturwertes, mit welchem die erste Taktfrequenz beaufschlagt wird und verringert einen möglichen Fehler bei der Ermittlung des Korrekturwertes welcher sich aufgrund von sehr großen Werten der Differenz ergeben würde. Wenn die Taktdifferenz im Zusammenhang mit der Synchronisation, also zeitnah zu einem Synchronisationszeitpunkt, ermittelt wird, dann hat die Taktdifferenz zwischen zweiter Taktfrequenz und Referenztaktfrequenz einen für dieses Verfahren maximal möglichen Wert, wodurch ein potentieller Fehler bei der Bestimmung der Taktdifferenz und im Folgenden des Korrekturwertes vermindert wird.

Zusätzlich oder alternativ erfolgt zu mindestens einem vorgegebenen oder vorgebbaren zweiten Zeitpunkt eine Synchronisation der ersten und der zweiten Taktfrequenz mit der Referenztaktfrequenz. Hieraus ergibt sich eine Vereinfachung der Beaufschlagung der ersten Taktfrequenz mit dem aus der Taktdifferenz zwischen der zweiten Taktfrequenz und der Referenztaktfrequenz mathematisch oder logisch abgeleiteten Korrekturwert sowie ein geringerer potentieller Fehler, da es zu keiner additiven oder multiplikativen Vergrößerung des Fehlers kommt.

Wird jeweils zumindest ein Korrekturwert für den ersten und mindestens einen weiteren Zeitpunkt ermittelt, zumindest ein mittlerer Korrekturwert aus den ermittelten Korrekturwerten gebildet und die erste Taktfrequenz mit dem mittleren Korrekturwert beaufschlagt, so ergibt sich eine Verbesserung des mittleren Korrekturwertes mit jedem zu dessen Ermittlung herangezogenen Korrekturwert. Es wird also eine Verbesserung des Korrekturwertes erreicht und mit steigender Anzahl gemittelter Korrekturwerte wird eine Verbesserung der Synchronität von erster Taktfrequenz und Referenztaktfrequenz und somit eine Qualitätsverbesserung erreicht.

Besonders bevorzugt sind ein erster Zeitpunkt und mindestens zwei weitere Zeitpunkte auf einer Zeitachse äquidistant zueinander angeordnet, wobei jeweils zwei aufeinander folgende Zeitpunkte ein Zeitintervall einschließen. Der Korrekturwert wird jeweils für ein solches Zeitintervall oder mindestens einen Teil davon ermittelt. Somit wird die Wahrscheinlichkeit die Bestimmung der Taktdifferenz gleichzeitig zu einem Auftreten mindestens eines die Takterzeugung beeinflussenden äußeren Ereignisses, z.B. kurzfristigen Temperaturschwankungen, durchzuführen, verringert. Die Taktdifferenz kann dabei über das gesamte Zeitintervall oder zumindest einen Teil des Zeitintervalls gemittelt oder integriert werden. Zusätzlich oder alternativ kann vorgesehen sein, dass für mehrere Zeitintervalle Taktdifferenzen und/oder Korrekturwerte gemittelt werden oder über mehrere Zeitintervalle oder Teile davon integriert werden. Durch das Mitteln und/oder das Integrieren der Taktdifferenz und/oder des Korrekturwertes wird deren qualitative Verbesserung erreicht, da beispielsweise eine Auswirkung kurzzeitiger äußerer Einflüsse wie einer Erschütterung, kurzzeitiger Erwärmung oder eines kurzfristig einwirkenden elektrischen Feldes oder mathematischer Fehler minimiert wird.

Zudem kann vorgesehen sein, dass entweder die Taktdifferenz oder der aus dieser abgeleitete Korrekturwert auf eine Anzahl von Takten der Referenztaktfrequenz bezogen wird, über welche entweder die Taktdifferenz oder der Korrekturwert integriert oder gemittelt wurde. Wurde die Taktdifferenz oder der Korrekturwert zu einem ersten Zeitpunkt bestimmt bzw. ermittelt und ist dieser Zeitpunkt einem vorangegangenen Zeitintervall zugeordnet, so wird die Taktdifferenz oder der Korrekturwert auf die Anzahl von Referenztaktfrequenz-Takten des Zeitintervalls bezogen. Hierdurch ergibt sich ein Korrekturwert pro Takt zur Beaufschlagung der ersten Taktfrequenz.

Bevorzugt sind die erste und die zweite Taktfrequenz so gewählt, dass eine Differenz dieser Taktfrequenzen im Wesentlichen gleich bleibt. Hierdurch wird sichergestellt, dass eine Abweichung zwischen der ersten Taktfrequenz und der zweiten Taktfrequenz konstant bleibt, also ein Faktor - ein Abweichungsfaktor-, um welchen sich beide Taktfrequenzen unterscheiden, konstant ist. Somit wird gewährleistet, dass eine Beaufschlagung der ersten Taktfrequenz mit dem Korrekturwert, gegebenenfalls unter Einbeziehung des Abweichungsfaktors, zu einer Annäherung der ersten Taktfrequenz an die Referenztaktfrequenz, also zu einer besseren Annäherung der ersten Taktfrequenz an die Referenztaktfrequenz, führt. Besonders bevorzugt sind die erste Taktfrequenz und die zweite Taktfrequenz im Wesentlichen gleich, was beispielsweise durch eine Verwendung von im Wesentlichen gleichen Taktfrequenzgebern erreicht wird, wobei "im Wesentlichen gleich" hier Taktfrequenzgeber meint, welche eine im Wesentlichen gleiche Taktfrequenz erzeugen und deren Taktfrequenzen sich beispielsweise bezüglich Drift im Wesentlichen gleich verhalten

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Darin zeigen
- FIG 1: eine schematisch vereinfachte Darstellung eines Automatisierungssystems mit einem ersten elektrischen Gerät, insbesondere einem ersten Automatisierungsgerät, zur Durchführung eines Verfahrens zur Korrektur einer Taktfrequenz,
- FIG 2: eine schematisch vereinfachte Darstellung des Verfahrens,
- FIG 3: eine schematisch vereinfachte Darstellung der Frequenz einer zweiten Taktfrequenz und einer Referenztaktfrequenz über der Zeit,
- FIG 4: eine schematisch vereinfachte Darstellung einer alternativen Ausführungsform des in FIG 2 dargestellten Verfahrens,
- FIG 5: eine schematisch vereinfachte Darstellung eines besonders bevorzugten Ausführungsbeispiels des in FIG 4 dargestellten Verfahrens und
- FIG 6: eine schematisch vereinfachte Darstellung eines elektrischen Gerätes zur Durchführung des Verfahrens.

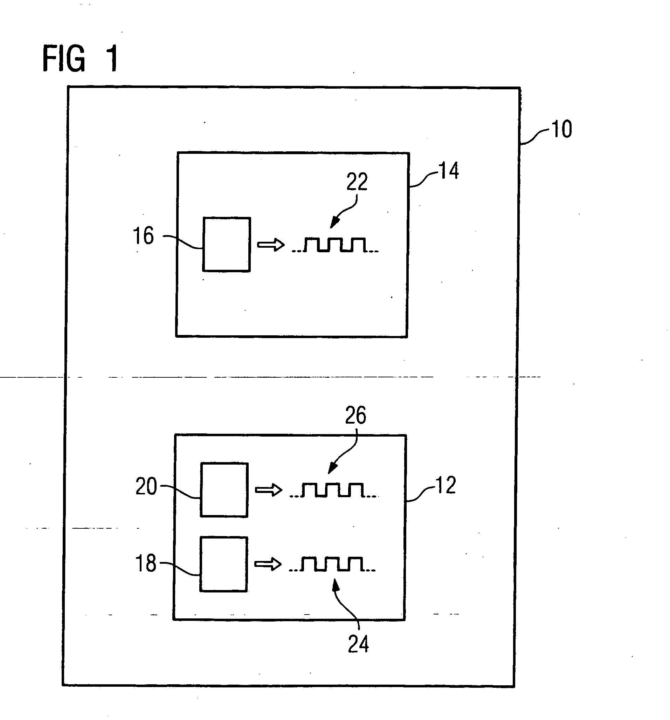

FIG 1 zeigt eine schematisch vereinfachte Darstellung eines Automatisierungssystems 10 mit einem ersten elektrischen Gerät, insbesondere einem ersten Automatisierungsgerät 12, zur Durchführung eines Verfahrens zur Korrektur einer Taktfrequenz und einem zweiten Automatisierungsgerät 14 mit einem Referenzfrequenzgeber 16. Alternativ kann der Referenzfrequenzgeber 16 entfernt von dem Automatisierungssystem 10 angeordnet sein. Dem ersten Automatisierungsgerät 12 ist ein erster Taktfrequenzgeber 18 und ein zweiter Taktfrequenzgeber 20 zugeordnet, wobei der Referenztaktfrequenzgeber 16 eine Referenztaktfrequenz 22, der erste Taktfrequenzgeber 18 eine erste Taktfrequenz 24 und der zweite Taktfrequenzgeber 20 eine zweite Taktfrequenz 26 erzeugt. Alternativ kann der zweite Taktfrequenzgeber 20 dem zweiten Automatisierungsgerät 14 oder einem weiteren Automatisierungsgerät zugeordnet sein.

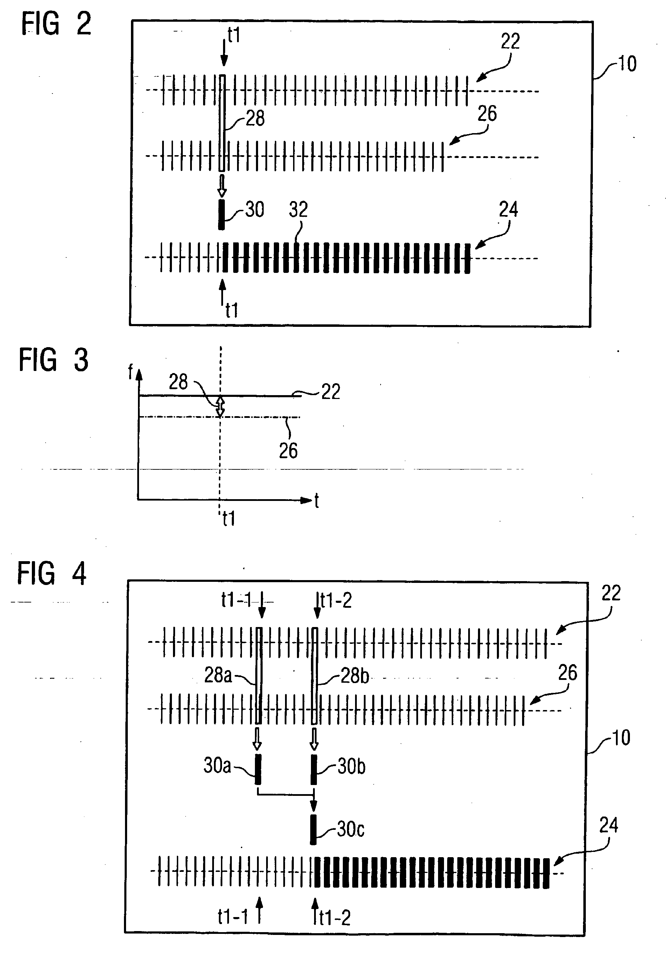

FIG 2 zeigt eine schematisch vereinfachte Darstellung des Verfahrens, wobei bei einem Betrieb des Automatisierungssystems 10 gemäß FIG 1 eine Korrektur der ersten Taktfrequenz 24 anhand der zweiten Taktfrequenz 26 sowie der Referenztaktfrequenz 22 erfolgt. Zu einem ersten Zeitpunkt t1 wird eine Taktdifferenz 28 zwischen der zweiten Taktfrequenz 26 und der Referenztaktfrequenz 22 ermittelt und aus der Taktdifferenz 28 ein Korrekturwert 30 abgeleitet, mit dem die erste Taktfrequenz 24 beaufschlagt wird, z.B. indem der Korrekturwert 30 zur ersten Taktfrequenz 24 addiert wird. Dabei wird jeder Takt 32 der ersten Taktfrequenz 24 mit dem Korrekturwert 30 beaufschlagt. Zudem kann im Zusammenhang mit der Ermittlung der Taktdifferenz 28, also zeitnah nach der Bestimmung der Taktdifferenz 28, eine Synchronisation der zweiten Taktfrequenz 26 mit der Referenztaktfrequenz 22, also eine Anpassung an die Referenztaktfrequenz 22, oder eine Synchronisation der zweiten Taktfrequenz 26 und der ersten Taktfrequenz 24 mit der Referenztaktfrequenz 22 erfolgen.

FIG 3 zeigt eine schematisch vereinfachte Darstellung der Frequenz f der zweiten Taktfrequenz 26 und der Referenztaktfrequenz 22 über der Zeit t, wobei eine Taktdifferenz 28 zwischen zweiter Taktfrequenz 26 und Referenztaktfrequenz 22 zum ersten Zeitpunkt t1 bestimmt wird. Die zweite Taktfrequenz 26 ist dabei im Wesentlichen konstant. Alternativ kann diese jedoch auch einer Änderung, z.B. durch Drift, unterliegen.

FIG 4 zeigt eine schematisch vereinfachte Darstellung einer alternativen Ausführungsform des in FIG 2 dargestellten Verfahrens, wobei für einen ersten Zeitpunkt t1-1 und einen weiteren Zeitpunkt t1-2 jeweils eine Taktdifferenz 28a, 28b ermittelt und daraus jeweils ein Korrekturwert 30a, 30b abgeleitet wird. Aus diesen Korrekturwerten 30a, 30b wird ein mittlerer Korrekturwert 30c gebildet und die erste Taktfrequenz 24 mit dem mittleren Korrekturwert 30c beaufschlagt.

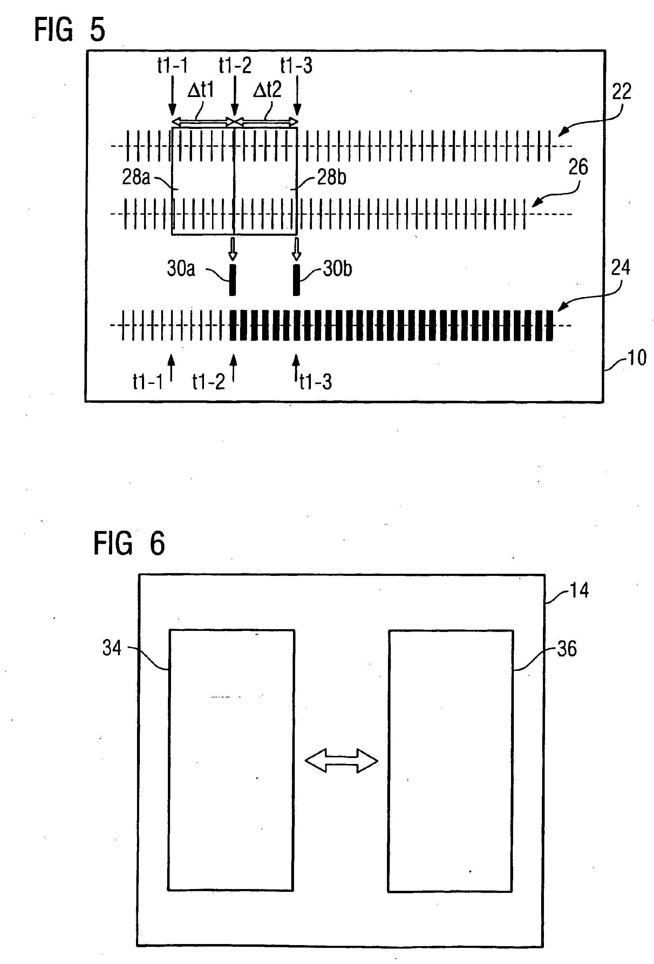

FIG 5 zeigt eine schematisch vereinfachte Darstellung eines besonders bevorzugten Ausführungsbeispiels des in FIG 4 dargestellten Verfahrens. Drei äquidistante Zeitpunkte t1-1, t1-2, t1-3 schließen zwei ebenfalls äquidistante sowie gleich lange Zeitintervalle Δt1, Δt2 ein. Für jedes Zeitintervall Δt1, Δt2 wird eine Taktdifferenz 28a, 28b zwischen der zweiten Taktfrequenz 26 und der Referenztaktfrequenz 22 ermittelt und jeweils ein Korrekturwert 30a, 30b abgeleitet, mit welchem die erste Taktfrequenz 24 beaufschlagt wird.

FIG 6 zeigt eine schematisch vereinfachte Darstellung eines elektrischen Gerätes, insbesondere eines Automatisierungsgerätes 12, mit einer Verarbeitungseinheit 34 und einem der Verarbeitungseinheit 34 zugeordneten Speicher 36, in dem ein Computerprogramm zur Durchführung des Verfahrens gespeichert ist und das durch die Verarbeitungseinheit 34 ausführbar ist.

Damit lässt sich die Erfindung kurz wie folgt darstellen: Die Erfindung betrifft ein Verfahren zum Betrieb eines elektrischen Gerätes, insbesondere eines Automatisierungsgerätes 12, bei dem eine Korrektur einer ersten Taktfrequenz 24 anhand einer zweiten Taktfrequenz 26 sowie einer Referenztaktfrequenz 22 erfolgt. Zu mindestens einem vorgegebenen oder vorgebbaren ersten Zeitpunkt t1 wird eine Taktdifferenz 28 zwischen der zweiten Taktfrequenz 26 und der Referenztaktfrequenz 22 bestimmt und aus der Taktdifferenz 28 ein Korrekturwert 30 abgeleitet, mit dem die erste Taktfrequenz 24 beaufschlagt wird.

## Patentansprüche

1. Verfahren zum Betrieb eines elektrischen Gerätes, insbesondere eines Automatisierungsgerätes (12), mit einem ersten und einem zweiten Taktfrequenzgeber (18, 20), die unabhängig voneinander eine erste bzw. zweite Taktfrequenz (24, 26) erzeugen,
bei dem eine Korrektur der ersten Taktfrequenz (24) anhand der zweiten Taktfrequenz (26) sowie einer unabhängig von der ersten und zweiten Taktfrequenz (24, 26) in einem von dem elektrischen Gerät entfernten Gerät erzeugten Referenztaktfrequenz (22) erfolgt,
wobei zu mindestens einem vorgegebenen oder vorgebbaren ersten Zeitpunkt (t1) eine Taktdifferenz (28) zwischen der zweiten Taktfrequenz (26) und der Referenztaktfrequenz (22) bestimmt wird
und aus der Taktdifferenz (28) ein Korrekturwert (30) abgeleitet wird, mit dem die erste Taktfrequenz (24) beaufschlagt wird.

2. Verfahren nach Anspruch 1, wobei zu dem oder jedem vorgegebenen oder vorgebbaren ersten Zeitpunkt (t1) eine Synchronisation der zweiten Taktfrequenz (26) mit der Referenztaktfrequenz (22) erfolgt und wobei im Zusammenhang mit der Synchronisation der zweiten Taktfrequenz (26) mit der Referenztaktfrequenz (22) die Taktdifferenz (28) zwischen der zweiten Taktfrequenz (26) und der Referenztaktfrequenz (22) bestimmt wird.

3. Verfahren nach Anspruch 1 oder 2, wobei zu mindestens einem vorgegebenen oder vorgebbaren zweiten Zeitpunkt (t2) eine Synchronisation der ersten und der zweiten Taktfrequenz (24, 26) mit der Referenztaktfrequenz (22) erfolgt.

4. Verfahren nach einem der vorangehenden Ansprüche, wobei jeweils zumindest ein Korrekturwert für den ersten und mindestens einen weiteren Zeitpunkt (t1-1, t1-2) ermittelt wird,
wobei zumindest ein mittlerer Korrekturwert (30c) aus den ermittelten Korrekturwerten (30a, 30b) gebildet wird und wobei die erste Taktfrequenz (26) mit dem mittleren Korrekturwert (30c) beaufschlagt wird.

5. Verfahren nach Anspruch 4, wobei ein erster Zeitpunkt und mindestens zwei weitere Zeitpunkte (t1-1, t1-2, t1-3) auf einer Zeitachse äquidistant zueinander angeordnet sind, wobei jeweils zwei aufeinander folgende Zeitpunkte (t1-1, t1-2) ein Zeitintervall (Δt) einschließen und wobei der Korrekturwert (28a) jeweils für das Zeitintervall (Δt1) oder mindestens einen Teil davon ermittelt wird.

6. Verfahren nach einem der vorangegangenen Ansprüche, wobei die erste und die zweite Taktfrequenz (24, 26) so gewählt sind, dass eine Differenz dieser Taktfrequenzen im Wesentlichen gleich bleibt.

7. Verfahren nach einem der vorangegangenen Ansprüche, wobei die erste Taktfrequenz (24) und die zweite Taktfrequenz (26) im Wesentlichen gleich sind.

8. Computerprogramm mit durch einen Computer ausführbaren Programmcodeanweisungen zur Implementierung des Verfahrens nach einem der Ansprüche 1 bis 7 wenn das Computerprogramm auf einem Computer ausgeführt wird.

9. Computerprogrammprodukt, insbesondere Speichermedium, mit einem durch einen Computer ausführbaren Computerprogramm gemäß Anspruch 8.

10. Elektrisches Gerät, insbesondere Automatisierungsgerät (12) mit Mitteln zur Durchführung des Verfahrens nach einem der Ansprüche 1 bis 7, insbesondere einer Verarbeitungseinheit (34) und einem der Verarbeitungseinheit (34) zugeordneten Speicher (36), in dem ein Computerprogramm nach Anspruch 8 gespeichert ist und das durch die Verarbeitungseinheit (34) ausführbar ist.

## Claims

1. Method for operating an electrical device, in particular an automation device (12), having a first and a second clock frequency generator (18, 20) which generate a first and a second clock frequency (24, 26) respectively, independently of one another,
wherein a correction of the first clock frequency (24) is effected on the basis of the second clock frequency (26) as well as of a reference clock frequency (22) generated independently of the first and second clock frequency (24, 26) in a device remote from the electrical device,
wherein a clock difference (28) between the second clock frequency (26) and the reference clock frequency (22) is determined at at least one predetermined or predeterminable first time point (t1)
and a correction value (30) which is derived from the clock difference (28) is applied to the first clock frequency (24).

2. Method according to claim 1, wherein a synchronisation of the second clock frequency (26) with the reference clock frequency (22) is effected at the or at each predetermined or predeterminable first time point (t1) and wherein the clock difference (28) between the second clock frequency (26) and the reference clock frequency (22) is determined in conjunction with the synchronisation of the second clock frequency (26) with the reference clock frequency (22).

3. Method according to claim 1 or 2, wherein a synchronisation of the first and of the second clock frequency (24, 26) with the reference clock frequency (22) is effected at at least one predetermined or predeterminable second time point (t2).

4. Method according to one of the preceding claims, wherein at least one correction value for the first time point and at least one further time point (t1-2, t1-2) is determined in each case, wherein at least one average correction value (30c) is formed from the determined correction values (30a, 30b) and
wherein the average correction value (30c) is applied to the first clock frequency (26).

5. Method according to claim 4, wherein a first time point and at least two further time points (t1-1, t1-2, t1-3) are arranged equidistant to one another on a time axis, wherein in each case two consecutive time points (t1-1, t1-2) frame a time interval (Δt) and wherein the correction value (28a) is determined in each case for the time interval (Δt1) or at least a part thereof.

6. Method according to one of the preceding claims, wherein the first and the second clock frequency (24, 26) are selected such that a difference in these clock frequencies remains essentially identical.

7. Method according to one of the preceding claims, wherein the first clock frequency (24) and the second clock frequency (26) are essentially identical.

8. Computer program with program code instructions which can be executed by a computer for implementing the method according to one of the claims 1 to 7 when the computer program is executed on a computer.

9. Computer program product, in particular storage medium, having a computer program according to claim 8 which can be executed by a computer.

10. Electrical device, in particular automation device (12) having means for carrying out the method according to one of the claims 1 to 7, in particular a processing unit (34) and a memory (36) associated with the processing unit (34), in which a computer program according to claim 8 is stored and can be executed by the processing unit (34).

## Revendications

1. Procédé pour faire fonctionner un appareil électrique, notamment un appareil ( 12 ) d'automatisation, comprenant un premier et un deuxième générateurs ( 18, 20 ) de fréquence d'horloge, qui produisent indépendamment l'un de l'autre une première et une deuxième fréquences ( 24, 26 ) d'horloge,
dans lequel on effectue une correction de la première fréquence ( 24 ) d'horloge au moyen de la deuxième fréquence ( 26 ) d'horloge ainsi qu'on produit une fréquence ( 22 ) d'horloge de référence produite indépendamment de la première et de la deuxième fréquences ( 24, 26 ) d'horloge dans un appareil éloigné de l'appareil électrique,
dans lequel, à au moins un premier instant ( t1 ) prescrit ou pouvant l'être, on détermine une différence ( 28 ) d'horloge entre la première fréquence ( 26 ) d'horloge et la fréquence ( 22 ) d'horloge de référence
et on déduit de la différence ( 28 ) d'horloge une valeur ( 30 ) de correction avec laquelle on corrige la première fréquence ( 24 ) d'horloge.

2. Procédé suivant la revendication 1, dans lequel, au premier instant ( t1 ) ou à chaque premier instant ( t1 ) prescrit ou pouvant l'être, on produit une synchronisation de la deuxième fréquence ( 26 ) d'horloge avec la fréquence ( 22 ) d'horloge de référence et dans lequel, en liaison avec la synchronisation de la deuxième fréquence ( 26 ) d'horloge avec la fréquence ( 22 ) d'horloge de référence, on détermine la différence ( 28 ) d'horloge entre la deuxième fréquence ( 26 ) d'horloge et la fréquence ( 22 ) d'horloge de référence.

3. Procédé suivant la revendication 1 ou 2, dans lequel, à au moins un deuxième instant ( t2 ) prescrit ou pouvant l'être, on produit une synchronisation de la première et de la deuxième fréquences ( 24, 26 ) d'horloge avec la fréquence ( 22 ) d'horloge de référence.

4. Procédé suivant l'une des revendications précédentes,
dans lequel on détermine respectivement au moins une valeur de correction pour le premier et au moins un autre instant ( t1-1, t1-2 ), dans lequel on forme au moins une valeurs ( 30c ) moyenne de correction à partir des valeurs ( 30a, 30b ) de correction déterminées et dans lequel on corrige la première fréquence ( 26 ) d'horloge avec la valeur ( 30c ) moyenne de correction.

5. Procédé suivant la revendication 4, dans lequel on met d'une manière équidistante les uns par rapport aux autres un premier instant et au moins deux autres instants ( t1-1, t1-2, t1-3 ) sur un axe du temps, dans lequel respectivement pour deux instants ( t1-1, t1-2 ) qui se succèdent on enferme un intervalle ( Δt ) de temps et dans lequel on détermine la valeur ( 28a ) de correction respectivement pour l'intervalle ( Δt1 ) de temps ou pour au moins une partie de celui-ci.

6. Procédé suivant l'une des revendications précédentes,
dans lequel on choisit la première et la deuxième fréquences ( 24, 26 ) d'horloge de façon à ce qu'une différence de ces fréquences d'horloge reste sensiblement la même.

7. Procédé suivant l'une des revendications précédentes, dans lequel la première fréquence ( 24 ) d'horloge et la deuxième fréquence ( 26 ) d'horloge sont sensiblement égales.

8. Programme informatique ayant des instructions de code de programme pouvant être réalisées sur un ordinateur pour la mise en oeuvre du procédé suivant l'une des revendications 1 à 7 lorsque le programme informatique est exécuté sur un ordinateur.

9. Produit de programme informatique, notamment support de mémoire, comprenant un programme informatique pouvant être exécuté par un ordinateur suivant la revendication 8.

10. Appareil électrique, notamment appareil ( 12 ) d'automatisation, comprenant des moyens pour effectuer le procédé suivant l'une des revendications 1 à 7, notamment une unité ( 34 ) de traitement et une mémoire ( 36 ) associée à l'unité ( 34 ) de traitement, mémoire dans laquelle est mémorisé un programme informatique suivant la revendication 8, ce programme pouvant être exécuté par l'unité ( 34 ) de traitement.
